# EUROPÄISCHE PATENTSCHRIFT

(11) **EP 4 294 600 B1**
(45) Veröffentlichungstag und Bekanntmachung des Hinweises auf die Patenterteilung: **02.04.2025**
(21) Anmeldenummer: 21815476.3
(22) Anmeldetag: 18.11.2021
(51) Int. Cl.: B25F 5/00, B25B 21/02

(54) **VORSPANNEINRICHTUNG FÜR EINE PLATINE**
PRETENSIONING DEVICE FOR A CIRCUIT BOARD
DISPOSITIF DE PRÉCONTRAINTE POUR UNE CARTE DE CIRCUIT INTÉGRÉ

(30) Priorität: 16.02.2021 EP 21157376
(43) Veröffentlichungstag der Anmeldung: 27.12.2023
(73) Patentinhaber: Hilti Aktiengesellschaft, 9494 Schaan (LI)
(72) Erfinder: LACHER, Michael, 86830 Schwabmünchen (DE); JAROMIN, Jerome, 81671 München (DE)
(74) Vertreter: Hilti Aktiengesellschaft Corporate Intellectual Property
(86) Internationale Anmeldenummer: PCT/EP2021/082071
(87) Internationale Veröffentlichungsnummer: WO 2022/174946

(56) Entgegenhaltungen:
- EP-A1- 1 995 121
- DE-A1- 102010 035 169
- DE-A1- 102019 116 539
- DE-T2- 69 401 040
- US-A1- 2014 254 100

## Beschreibung

Die vorliegende Erfindung betrifft eine Steuerungsvorrichtung für eine Werkzeugmaschine enthaltend wenigstens eine Platine, ein Wärmeleitelement, eine Kühleinrichtung zum Kühlen der wenigstens einen Platine sowie wenigstens ein Gehäuseelement, wobei in einem montierten Zustand der Steuerungseinrichtung die Platine und das Wärmeleitelement zwischen der Kühleinrichtung und dem Gehäuseelement angeordnet sind und wobei das Wärmeleitelement zwischen der Platine und der Kühleinrichtung positioniert ist.

Aus dem Stand der Technik sind Steuerungsvorrichtungen für Werkzeugmaschinen weitestgehend bekannt. Die Steuerungseinrichtung dient zum Steuern bzw. Regeln der Funktionen der Werkzeugmaschine, wie beispielsweise die Drehzahl des Antriebs (z.B. Elektromotor) der Werkzeugmaschine. Die Steuerungsvorrichtung kann auch als Steuer- und Regelvorrichtung oder Regelvorrichtung bezeichnet werden.

Die Entwicklung von Wärme kann in der Steuerungsvorrichtung problematisch sein, da zu hohe Temperaturen im Inneren der Steuerungsvorrichtung zu Beschädigungen an einzelnen Komponenten der Steuerungsvorrichtung und/oder zu einem Totalausfall der Werkzeugmaschine führen können.

Aus dem Stand der Technik sind bereits verschiedene Kühleinrichtungen weitestgehend bekannt. Die Konstruktionen bzw. der Aufbau von Steuerungsvorrichtungen mit derartigen Kühleinrichtungen und insbesondere die Anbindung von wärmeerzeugenden Komponenten, wie beispielsweise Platinen mit Kondensatoren, Spulen oder anderen Bauteilen, an die Kühleinrichtungen ist oftmals komplex, kostenintensiv und zu wenig effektiv. Eine Steuerungsvorrichtung gemäß dem Oberbegriff des Anspruchs 1 ist bereits aus der US 2014/254100 bekannt.

Aufgabe der vorliegenden Erfindung ist es daher, eine Steuerungsvorrichtung für eine Werkzeugmaschine enthaltend wenigstens eine Platine, ein Wärmeleitelement, eine Kühleinrichtung zum Kühlen der wenigstens einen Platine sowie wenigstens ein Gehäuseelement, wobei in einem montierten Zustand der Steuerungseinrichtung die Platine und das Wärmeleitelement zwischen der Kühleinrichtung und dem Gehäuseelement angeordnet sind und wobei das Wärmeleitelement zwischen der Platine und der Kühleinrichtung positioniert ist bereitzustellen, welche wenigstens die vorstehend genannten Probleme löst.

Die Aufgabe wird jeweils gelöst durch den Gegenstand des unabhängigen Anspruchs 1.

Weitere vorteilhafte Ausgestaltungsformen der Erfindung finden sich in den entsprechenden Unteransprüchen.

Die Aufgabe wird insbesondere gelöst durch eine Steuerungsvorrichtung für eine Werkzeugmaschine enthaltend wenigstens eine Platine, ein Wärmeleitelement, eine Kühleinrichtung zum Kühlen der wenigstens einen Platine sowie wenigstens ein Gehäuseelement, wobei in einem montierten Zustand der Steuerungseinrichtung die Platine und das Wärmeleitelement zwischen der Kühleinrichtung und dem Gehäuseelement angeordnet sind und wobei das Wärmeleitelement zwischen der Platine und der Kühleinrichtung positioniert ist.

Erfindungsgemäß ist eine Vorspanneinrichtung zwischen dem Gehäuseelement und der Platine enthalten, um die wenigstens eine Platine in eine vorbestimmte Richtung gegen das Wärmeleitelement zu drücken. Hierdurch wird eine bessere thermische Anbindung der wärmeerzeugenden Platine zu der Kühleinrichtung erreicht, sodass insgesamt die Kühlung der Steuerungsvorrichtung verbessert werden kann.

Das Wärmeleitelement kann dabei wenigstens teilweise aus Metall oder einer Metalllegierung hergestellt sein. Es ist möglich, dass das Wärmeleitelement wenigstens teilweise aus Kupfer besteht.

Die Steuerungsvorrichtung kann auch als Steuerungs- und Regelungsvorrichtung bzw. als Regelungsvorrichtung bezeichnet werden.

Erfindungsgemäß enthält die Vorspanneinrichtung wenigstens ein erstes Federelement und ein zweites Federelement.

Das erste und zweite Federelement weist dabei unterschiedliche Formen bzw. Ausgestaltungen aus. Das erste Federelement kann dabei ein größeres Volumen bzw. eine größere Dimension aufweisen als das zweite Federelement. Durch die unterschiedlichen Ausgestaltungen des ersten und zweiten Federelements ist es möglich, dass die Vorspanneinrichtung auf die Platine und das Wärmeleitelement an unterschiedlichen Stellen verschieden viel Kraft bzw. Druck ausübt.

Erfindungsgemäß weist das erste Federelement eine erste Erstreckung in eine vorbestimmte Richtung und das zweite Federelement eine zweite Erstreckung in die vorbestimmte Richtung auf.

Hierdurch kann das erste Federelement an einer bestimmten Position der Platine bzw. des Wärmeleitelements eine andere Kraft bzw. einen anderen Druck ausübt als das zweite Federelement. Mit anderen Worten: die unterschiedlich hohen Federelemente können hierdurch entsprechend unterschiedliche Anpresskräfte bzw. Anpressdrücke ausüben. Die Erstreckung der Federelemente kann auch als Erhebung oder Höhe bezeichnet werden.

Entsprechend einer vorteilhaften Ausführungsform der vorliegenden Erfindung kann es möglich sein, dass die Vorspanneinrichtung wenigstens teilweise aus einem elastischen Werkstoff ausgestaltet ist. Hierdurch weist die Vorspanneinrichtung eine federnde Funktion auf. Darüber hinaus kann durch die Verwendung des elastischen Werkstoffs die Vorspanneinrichtung leichter und vor allem flexibel in der Steuerungsvorrichtung positioniert werden.

Es ist gemäß einer alternativen Ausgestaltung möglich, dass die Vorspanneinrichtung eine Matte enthält. Die Matte dient dazu, die die Federelemente miteinander zu verbinden.

Gemäß einer vorteilhaften Ausführungsform der vorliegenden Erfindung kann es möglich sein, dass die Vorspanneinrichtung wenigstens teilweise aus Silikon ausgestaltet ist. Hierdurch ist eine flexible Anpassung der Vorspanneinrichtung in der Steuerungsvorrichtung erreicht werden.

Weitere Vorteile ergeben sich aus der folgenden Figurenbeschreibung. In den Figuren sind verschiedene Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmässigerweise auch einzeln betrachten und zu sinnvollen weiteren Kombinationen zusammenfassen.

Es zeigen:
- Figur 1: eine Seitenansicht auf eine Werkzeugmaschine mit einer erfindungsgemäßen Steuerungsvorrichtung gemäß einer ersten Ausführungsform;
- Figur 2: eine perspektivische Ansicht auf die Komponenten der erfindungsgemäßen Steuerungsvorrichtung gemäß einer zweiten Ausführungsform mit einer Kühleinrichtung, einem ersten Gehäuseelement, einem Wärmeleitelement, einer ersten Platine, einer Vorspanneinrichtung, einer zweiten Platine und einem zweiten Gehäuseelement;
- Figur 3: eine perspektivische Ansicht auf die Vorspanneinrichtung mit einer Anzahl an ersten und zweiten Federelementen; und
- Figur 4: eine Detailansicht auf die erfindungsgemäße Steuerungsvorrichtung gemäß der ersten Ausführungsform.

### Ausführungsbeispiele:

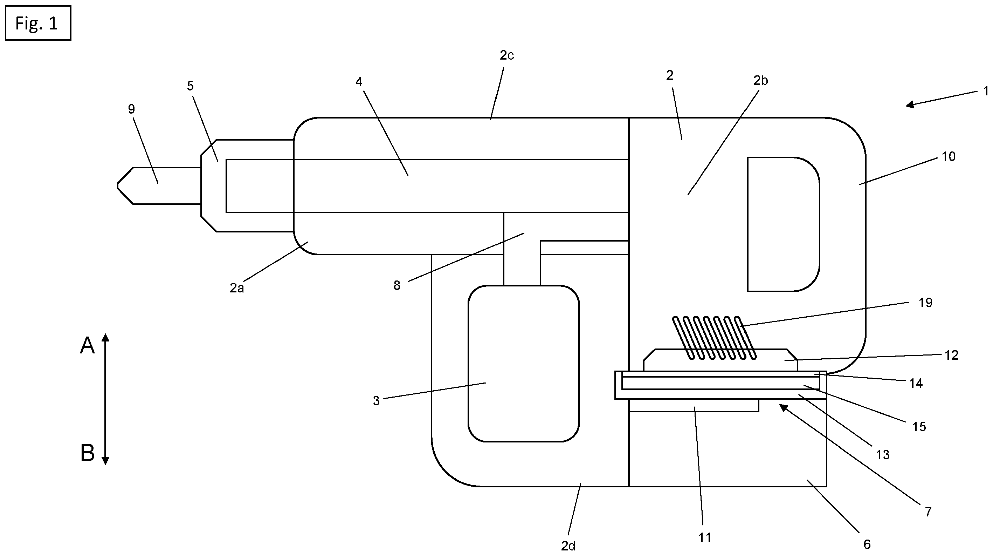

In Figur 1 ist eine Werkzeugmaschine 1 in Form eines Bohrhammers gezeigt. Die als Bohrhammer ausgestaltete Werkzeugmaschine 1 enthält dabei im Wesentlichen ein Gehäuse 2, einen Antrieb 3, ein Schlagwerk 4, eine Werkzeugaufnahme 5, eine Energieversorgung 6 und eine Steuerungsvorrichtung 7.

Der Antrieb 3 kann in Form eines Elektromotors ausgestaltet sein. Der als Elektromotor ausgestaltete Antrieb 3 dient zum Erzeugen eines Drehmoments, das über ein Getriebe 8 an das Schlagwerk 4 übertragen wird. Das Schlagwerk 4 erzeugt pulsartige Schläge, die mit Hilfe der Werkzeugaufnahme 5 auf ein in der Werkzeugaufnahme aufgenommenes und gehaltenes Werkzeug 9 übertragen werden können. Der Antrieb 3, das Getriebe 8 und auch das Schlagwerk 4 sind im Inneren des Gehäuses 2 positioniert.

Alternativ kann die Werkzeugmaschine 1 anstelle eines Bohrhammers auch als Säge, Schleifgerät oder dergleichen ausgestaltet sein.

Das Gehäuse 2 weist ein vorderes Ende 2a, ein hinteres Ende 2b, ein oberes Ende 2c und ein unteres Ende 2d auf. An dem hinteren Ende 2b des Gehäuses 2 ist ein Handgriff 10 positioniert. Der Handgriff 10 dient zum Halten und Führen der Werkzeugmaschine 1. Gegenüberliegend an dem vorderen Ende 2a des Gehäuses 2 ist die Werkzeugaufnahme 5 positioniert. Die Werkzeugaufnahme 5 dient zum Aufnehmen und Halten des Werkzeugs 5. Wenn die Werkzeugmaschine 1 als Bohrhammer ausgestaltet ist, ist das Werkzeug 9 als Bohrer oder Meißel ausgestaltet.

Die Energieversorgung 6 dient zur Versorgung der Werkzeugmaschine 1 mit elektrischer Energie. Wie in Figur 1 angedeutet ist die Energieversorgung 6 als ein Akkumulator ausgestaltet. Der Akkumulator 6 ist wiederlösbar über eine Schnittstelle 11 mit dem unteren Ende 2d bzw. hinteren Ende 2b des Gehäuses 2 verbindbar. Alternativ kann die Energieversorgung 6 anstelle eines Akkumulators auch als Netzteil ausgestaltet sein, mit dem die Werkzeugmaschine 1 wiederlösbar mit einer Steckdose verbindbar ist.

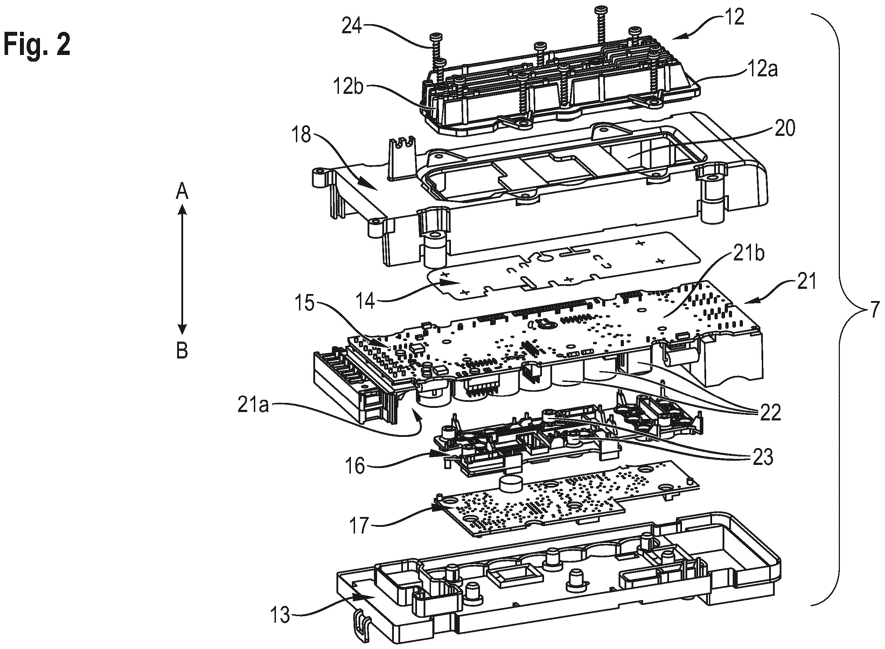

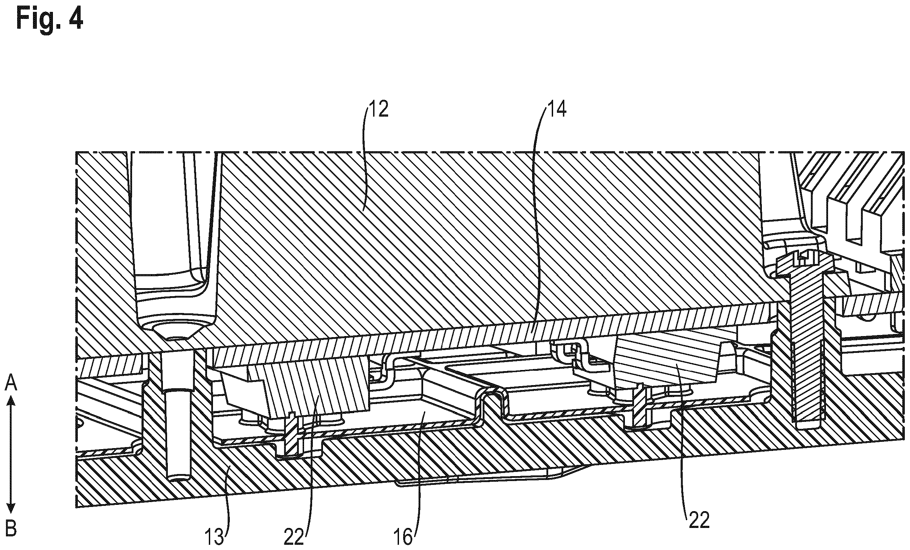

In Figur 1 und 4 ist die Steuerungsvorrichtung 7 gemäß einer ersten Ausführungsform gezeigt. Figur 2 zeigt die Steuerungsvorrichtung 7 gemäß einer zweiten Ausführungsform.

Die Steuerungsvorrichtung 7 ist im Wesentlichen an dem hinteren und unteren Ende 2b, 2d des Gehäuses 2 positioniert und dient zum Steuern und Regeln der unterschiedlichen Funktionen der Werkzeugmaschine 1. Eine dieser Funktionen ist beispielsweise die Drehzahl des als Elektromotor ausgestalteten Antriebs 3. Gemäß der ersten Ausführungsform weist die Steuerungsvorrichtung 7 eine Kühleinrichtung 12, ein Gehäuseelement 13, ein Wärmeleitelement 14, eine Platine 15 und eine Vorspanneinrichtung 16, vgl. Figur 1 und 4.

Gemäß der zweiten Ausführungsform weist die Steuerungsvorrichtung 7 eine Kühleinrichtung 12, ein erstes Gehäuseelement 13, ein Wärmeleitelement 14, eine erste Platine 15, eine Vorspanneinrichtung 16, eine zweite Platine 17 und ein zweites Gehäuseelement 18, vgl. Figur 2. Das erste Gehäuseelement 13 ist ein in Richtung B untere Gehäuseelement. Das zweite Gehäuseelement 18 ist ein in Richtung A oberes Gehäuseelement.

Wie in den Figuren 1 und 4 erkennbar handelt es sich bei dem ersten (und einzigen) Gehäuseelement 13 der ersten Ausführungsform der Steuerungsvorrichtung 7, um das in Richtung B untere Gehäuseelement.

Die Kühleinrichtung 12 ist im Wesentlichen in Form einer Grundplatte 12a mit abstehenden Kühlelementen 12b ausgestaltet. Die Kühlelemente 12b sind als Kühlrippen ausgestaltet. Die Kühlrippen können auch als Kühlfinnen bezeichnet werden. Mit Hilfe der Kühleinrichtung 12 kann die Übertragung von Wärme, die in dem Inneren der Steuerungsvorrichtung 7 erzeugt wird, an die Umgebung und damit die eigentliche Kühlung erreicht werden. Wie in Figur 2 erkennbar ist die Kühleinrichtung 12 hinter bzw. neben Lüftungsöffnungen 19 des Gehäuses 2 der Werkzeugmaschine 1 angeordnet. Durch die Lüftungsöffnungen 19 kann Luft in das Innere des Gehäuses 2 der Werkzeugmaschine 1 und entlang der als Kühlrippen ausgestalteten Kühlelemente 19 strömen.

Wie in Figur 2 gezeigt ist das zweite Gehäuseelement 18 in Form eines Deckels ausgestaltet. An einer Oberseite des ersten Gehäuseelements 18 ist eine Aussparung 20 vorgesehen, über der das Kühlelement 12b befestigt wird.

Das Wärmeleitelement 14 ist in Form einer flachen Matte aus einem wärmeleitfähigen Werkstoff ausgestaltet. Bei dem wärmeleitfähigen Werkstoff handelt sich um Kupfer. Das Wärmeleitelement 14 ist in Richtung B unterhalb des zweiten als Becher ausgestalteten Gehäuseelements 18 positioniert.

Die erste Platine 15 ist als Leistungsleiterplatte ausgestaltet und in Richtung B unter dem Wärmeleitelement 14 positioniert. Wie insbesondere in Figur 2 ersichtlich besteht die erste Platine 15 aus der eigentlichen Trägerplatte 21 und einer Anzahl an elektrischen bzw. elektronischen Bauteilen 22. Bei den Bauteilen 22 kann es sich beispielsweise um Kondensatoren, Spulen, Transistoren oder dergleichen handeln. Die Trägerplatte 21 enthält dabei eine erste Seite 21a und zweite Seite 21b. Diese Bauteile 22 sind an der ersten Seite 21a der Leiterplatte befestigt. An der zweiten Seite 21b sind hingegen keine Bauteile befestigt, sodass die zweite Seite 21b im Wesentlichen flach ausgestaltet ist. Die erste Platine 15 ist so in der Steuerungsvorrichtung 7 positioniert, dass die erste Seite 21a der Trägerplatte 21 mit den Bauteilen 22 in Richtung B und die zweite (flache) Seite 21b der Trägerplatte 21 in Richtung A zeigt.

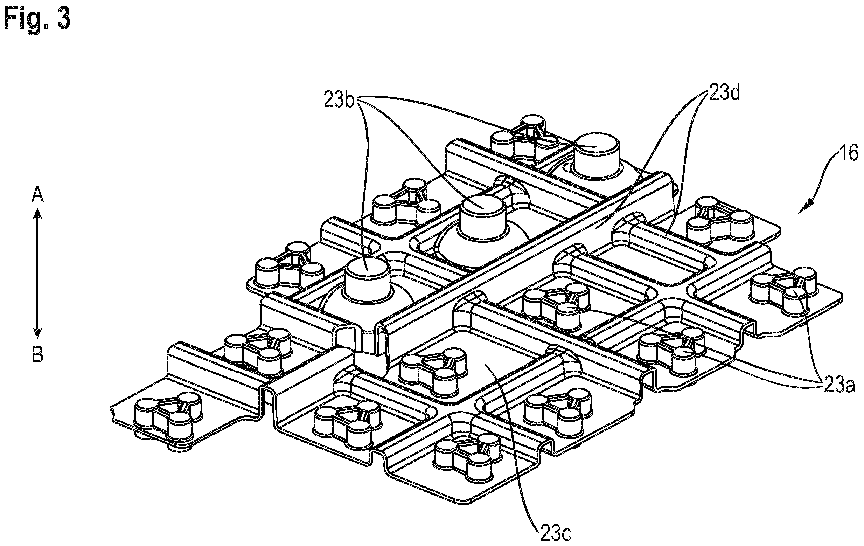

Die Vorspanneinrichtung 16 ist in Form einer elastischen Matte mit einer Anzahl an Federelementen 23 ausgestaltet. In Figur 3 ist eine beispielhafte Ausführungsform der Vorspanneinrichtung 16 gezeigt, bei der dreizehn Federelemente 23 in Form von kleinen dreieckigen Erhebungen 23a sowie drei Federelemente 23 in Form von großen zylindrischen Erhebungen 23b auf einer Matte 23c positioniert sind. Zwischen den einzelnen Federelementen 23 sind Stege 23d in Form von länglichen Erhebungen vorhanden. Alternativ können mehr oder weniger als drei große und dreizehn kleine Federelemente 23 vorhanden sein. Die Anzahl, Form und Position der großen und kleinen Erhebungen richten sich nach der Anzahl, Form und Position der elektrischen bzw. elektronischen Bauteilen 22 an der ersten Platine 15. Jede kleiner ein Bauteil 22 auf der ersten Platine 15 ist, d.h. je kürzer ein Bauteil 22 sich in Richtung B von der ersten Seite 21a der Platine 15 erstreckt, desto größer ist das Federelement 23 auf der Vorspanneinrichtung 16, d.h. desto weiter erstreckt sich das als Erhebung ausgestaltete Federelement 23 in Richtung A von der Matte.

Die Vorspannenrichtung 16 dient zum Ausüben von Kraft bzw. Druck auf die erste Platine 15, sodass in einem montierten Zustand der Steuerungsvorrichtung 7 die erste Platine 15 in Richtung A auf das Wärmeleitelement 14 und die Kühleinrichtung 12 gedrückt wird. Innerhalb eines linearen Bereichs besteht der Zusammenhang, je stärker die wärmeerzeugende Platine 15 in Richtung A an das Wärmeleitelement 14 und die Kühleinrichtung 12 gedrückt wird, desto besser erfolgt die Wärmeübertragung von der ersten Platine 15 zu der Kühleinrichtung 12.

Das erste Gehäuseelement 13 ist in Form eines relativ flachen Deckels ausgestaltet. In das als Deckel ausgestaltete erste Gehäuseelement 13 dient zum Aufnehmen der beiden Platinen 15, 17 und der zwischen den beiden Platinen 15, 17 angeordneten Vorspanneinrichtung 16. Die erste Platine 15, die zweite Platine 17, die Vorspanneinrichtung 16, das Wärmeleitelement 14 und die Kühleinrichtung 12 sind damit zwischen den beiden Gehäuseelementen 13, 18 positioniert.

Wie bereits erwähnt kann gemäß der ersten Ausführungsform der Steuerungsvorrichtung 7 das obere Gehäuseelement 18 weggelassen werden.

Zur Montage bzw. zum Zusammenfügen der Steuerungsvorrichtung 7 gemäß der ersten Ausführungsform wird die Kühleinrichtung 12 mit dem unteren als Deckel ausgestalteten Gehäuseelement 18 verschraubt, sodass ein Zwischenraum zwischen der Kühleinrichtung 12 und dem Gehäuseelement 13 entsteht. In den Zwischenraum sind das Wärmeleitelement 14, die Platine 15 und die Vorspanneinrichtung 16 positioniert, vgl. Figur 1 und 4.

Im Gegensatz dazu wird zur Montage bzw. zum Zusammenfügen der Steuerungsvorrichtung 7 gemäß der zweiten Ausführungsform die Kühleinrichtung 12 mit dem ersten als Becher ausgestalteten Gehäuseelement 18 verschraubt. Das erste (obere) Gehäuseelement 13 wird mittels Schrauben 24 wiederum mit dem zweiten (unteren) als Deckel ausgestalteten Gehäuseelement 18 verschraubt. Wiederum wird ein Zwischenraum zwischen dem ersten (oberen) Gehäuseelement 13 und dem zweiten (unteren) Gehäuseelement 18 erzeugt, in den das Wärmeleitelement 14, die erste Platine 15, die Vorspanneinrichtung 16 und die zweite Platine 17 positioniert sind, vgl. Figur 2.

### Bezugszeichen:

- 1: Werkzeugmaschine
- 2: Gehäuse
- 2a: vorderes Ende des Gehäuses
- 2b: hinteres Ende des Gehäuses
- 2c: ein oberes Ende des Gehäuses
- 2d: des unteres Ende Gehäuses
- 3: Antrieb
- 4: Schlagwerk
- 5: Werkzeugaufnahme
- 6: Energieversorgung
- 7: Steuerungsvorrichtung
- 8: Getriebe
- 9: Werkzeug
- 10: Handgriff
- 11: Schnittstelle
- 12: Kühleinrichtung
- 12a: Grundplatte
- 12b: Kühlelement
- 13: erstes Gehäuseelement
- 14: Wärmeleitelement
- 15: erste Platine
- 16: Vorspanneinrichtung
- 17: zweite Platine
- 18: zweites Gehäuseelement
- 19: Lüftungsöffnungen
- 20: Aussparung
- 21: Trägerplatte
- 21a: erste Seite der Trägerplatte
- 21b: zweite Seite der Trägerplatte
- 22: Bauteil
- 23: Federelement
- 23a: kleine dreieckige Erhebung
- 23b: große zylindrische Erhebung
- 23c: Matte
- 23d: Steg
- 24: Schraube

## Patentansprüche

1. Steuerungsvorrichtung (7) für eine Werkzeugmaschine (1) enthaltend wenigstens eine Platine (15), ein Wärmeleitelement (14), eine Kühleinrichtung (12) zum Kühlen der wenigstens einen Platine (15) sowie wenigstens ein Gehäuseelement (13), wobei in einem montierten Zustand der Steuerungsvorrichtung (7) die Platine (15) und das Wärmeleitelement (14) zwischen der Kühleinrichtung (12) und dem Gehäuseelement (13) angeordnet sind und wobei das Wärmeleitelement (14) zwischen der Platine (15) und der Kühleinrichtung (12) positioniert ist,
wobei eine Vorspanneinrichtung (16) zwischen dem Gehäuseelement (13) und der wenigstens einen Platine (15) enthalten ist, um die Platine (15) in eine vorbestimmte Richtung (A) gegen das Wärmeleitelement (14) zu drücken, wobei die Vorspanneinrichtung (16) wenigstens ein erstes Federelement (23a) und ein zweites Federelement (23b) enthält
**dadurch gekennzeichnet, dass** das erste Federelement (23a) eine erste Erstreckung in eine Richtung (A) und das zweite Federelement (23b) eine zweite Erstreckung in die Richtung (A) und somit eine unterschiedliche Höhe aufweisen.

2. Steuerungsvorrichtung (7) nach Anspruch 1, **dadurch gekennzeichnet, dass** die Vorspanneinrichtung (16) wenigstens teilweise aus einem elastischen Werkstoff ausgestaltet ist.

3. Steuerungsvorrichtung (7) nach wenigstens einem der Ansprüche 1 bis 2, **dadurch gekennzeichnet, dass** die Vorspanneinrichtung (16) wenigstens teilweise aus Silikon ausgestaltet ist.

## Claims

1. Control apparatus (7) for a power tool (1) containing at least one circuit board (15), a heat-conducting element (14), a cooling device (12) for cooling the at least one circuit board (15), and at least one housing element (13), wherein, in a mounted state of the control apparatus (7), the circuit board (15) and the heat-conducting element (14) are arranged between the cooling device (12) and the housing element (13), and wherein the heat-conducting element (14) is positioned between the circuit board (15) and the cooling device (12),
wherein a preload device (16) is included between the housing element (13) and the at least one circuit board (15) in order to press the circuit board (15) against the heat-conducting element (14) in a predetermined direction (A), wherein the preload device (16) comprises at least one first spring element (23a) and one second spring element (23b),
**characterized in that** the first spring element (23a) has a first extent in a direction (A) and the second spring element (23b) has a second extent in the direction (A) and therefore has a different height.

2. Control apparatus (7) according to Claim 1,
**characterized in that** the preload device (16) is configured at least partially from a resilient material.

3. Control apparatus (7) according to at least one of Claims 1 to 2,
**characterized in that** the preload device (16) is configured at least partially from silicone.

## Revendications

1. Dispositif de commande (7) pour une machine-outil (1) contenant au moins une carte à circuit imprimé (15), un élément (14) conducteur de chaleur, un dispositif de refroidissement (12) pour refroidir ladite au moins une carte à circuit imprimé (15) ainsi qu'au moins un élément de boîtier (13), dans lequel, dans un état monté du dispositif de commande (7), la carte à circuit imprimé (15) et l'élément (14) conducteur de chaleur sont agencés entre le dispositif de refroidissement (12) et l'élément de boîtier (13), et dans lequel l'élément (14) conducteur de chaleur est positionné entre la carte à circuit imprimé (15) et le dispositif de refroidissement (12),
un moyen de sollicitation (16) étant inclus entre l'élément de boîtier (13) et ladite au moins une carte à circuit imprimé (15) pour presser la carte à circuit imprimé (15) dans une direction prédéterminée (A) contre l'élément (14) conducteur de chaleur, le moyen de sollicitation (16) comprenant au moins un premier élément à ressort (23a) et un deuxième élément à ressort (23b),
**caractérisé en ce que** le premier élément à ressort (23a) présente une première extension dans une direction (A) et le deuxième élément à ressort (23b) présente une deuxième extension dans la direction (A) et donc une hauteur différente.

2. Dispositif de commande (7) selon la revendication 1,
**caractérisé en ce que** le dispositif de sollicitation (16) est réalisé au moins partiellement en un matériau élastique.

3. Dispositif de commande (7) selon au moins l'une des revendications 1 à 2,
**caractérisé en ce que** le dispositif de sollicitation (16) est réalisé au moins partiellement en silicone.
